# EUROPÄISCHE PATENTSCHRIFT

(11) **EP 1 001 050 B1**
(45) Veröffentlichungstag und Bekanntmachung des Hinweises auf die Patenterteilung: **27.07.2005**
(21) Anmeldenummer: 99120361.3
(22) Anmeldetag: 13.10.1999
(51) Int. Cl.: C23C 16/44, C23C 16/18, C23C 16/40, C23C 16/34, C23C 16/46, C23C 16/48, C23C 16/50, G21K 1/06, C23C 16/04, C23C 16/52

(54) **Verfahren zur Innenbeschichtung von Kapillaren und deren Verwendung**
Process for internal coating of capillaries and use of such capillaries
Procédé de revêtement interieur des capillaires et utilisation des tels capillaires

(30) Priorität: 16.11.1998 DE 19852722
(43) Veröffentlichungstag der Anmeldung: 17.05.2000
(73) Patentinhaber: Forschungszentrum Karlsruhe GmbH, 76133 Karlsruhe (DE)
(72) Erfinder: Heck, Jürgen, Prof. Dr., 22926 Ahrensburg (DE); Kneip, Stefan, Dr., 66798 Wallerfangen (DE); Knöchel, Arndt, Prof. Dr., 22393 Hamburg (DE); Haller, Martin, Dr., 20144 Hamburg (DE); Moritz, Florian, 22765 Hamburg (DE)

(56) Entgegenhaltungen:
- EP-A- 0 348 690
- DE-C- 4 444 102
- GB-A- 2 079 742
- US-A- 3 158 499
- US-A- 5 014 646
- US-A- 5 286 534
- US-A- 5 385 595
- US-A- 5 415 891

## Beschreibung

Die Erfindung betrifft ein Verfahren zur Innenbeschichtung von Kapillaren und deren Verwendung.

Aus der U.S. 5,130,172 ist die Metall-Beschichtung von Oberflächen mit Hilfe der chemischen Gasphasenabscheidung beschrieben. Es findet sich jedoch kein Hinweis, wie mit Hilfe dieses Verfahrens Kapillaren beschichtet werden können. Zur Innenbeschichtung makroskopischer Kapillaren (mit einem Innendurchmesser oberhalb von Millimetern) sind hauptsächlich naßchemische Verfahren geeignet (z. B. Silberspiegelverfahren).

Des weiteren ist aus der DE 32 04 846 A1 ein Plasmaverfahren zur Innenbeschichtung von Glasrohren durch reaktive Abscheidung aus einem durch das Rohr strömenden Gas bekannt. Diese Rohre werden anschließend zu einer Faser gezogen.

Die Innenbeschichtung eines Röhrchens, welches beispielsweise aus Glas bestehen kann, mit einem Siloxan, d.h. ausgehend von einer metallorganischen Verbindung, mit Hilfe eines Plasmaverfahrens, bei dem der Transport des Prozeßgases durch einen Druckgradienten geschieht und die Evakuierung des Röhrchens vorgesehen ist, ist aus der EP-A-0 348 690 bekannt.

Aufgabe der Erfindung ist es, ein weiteres Verfahren, mit dem Kapillaren mit Metallschichten unterschiedlicher Qualität innen beschichtet werden können, sowie einige Verwendungen für so hergestellte Kapillaren anzugeben.

Gelöst wird diese Aufgabe durch die Merkmale der Patentansprüche 1, 10 und 11. Die Unteransprüche beschreiben vorteilhafte Ausgestaltungen des Verfahrens.

Die erfindungsgemäße Technik gestattet als einzige die Innenbeschichtung von Mikrokapillaren mit einem Innendurchmesser von 500 - 0,1 µm. Weitere beachtliche Vorteile gegenüber den naßchemischen Verfahren liegen in der wesentlich verbesserten Schichtgüte in bezug auf Rauhigkeit, Dicke und Homogenität sowie der Möglichkeit, Metallschichten nahezu beliebiger Elementzusammensetzung - auch und insbesondere von mehrkomponentigen Systemen - aufzubringen. Dabei ist die Haftung der Metallfilme auf der Glasoberfläche in unserem Verfahren außerordentlich gut.

Für katalytische Zwecke werden vorzugsweise Kapillaren mit einem Innendurchmesser von 50 - 200 µm verwendet.

Die besonderen Vorteile des Beschichtungsverfahrens resultieren vor allem aus der Tatsache, daß die Abscheidung der Schichten aus homogener Gasphase erfolgt. Dadurch entstehen hochreine Schichtsysteme von hoher Qualität in bezug auf Zusammensetzung und Oberflächeneigenschaften. Naßchemische Verfahren genügen den Anforderungen, die z. B. die Röntgentechnik in bezug auf Oberflächenbeschaffenheit und Schichthomogenität hat, in der Regel nicht. Auch lassen sich Mikrokapillaren mit Innendurchmessern unterhalb von 100 Mikrometern mit klassischen naßchemischen Methoden bisher nicht beschichten.

Neben allen Vorteilen, die auch die klassische CVD-Technik gegenüber Konkurrenzverfahren wie PVD oder Molekularstrahlepitaxie bietet, zeichnet sich unser spezielles Verfahren zur Beschichtung von Mikrokapillaren durch eine einfache, leicht kontrollierbare Beschichtungsmethodik aus. Die sehr große Zahl einsetzbarer Precursorverbindungen (Vorläuferverbindungen) wird nur durch die Anforderungen an die Flüchtigkeit (Verdampfungstemperatur kleiner als 200 °C bei einem Druck von 10⁻³ mbar) limitiert. Es können nahezu alle Substanzen als Precursor eingesetzt werden, die auch beim makroskopischen CVD-Verfahren Verwendung finden. Die bisher eingesetzten Organometallverbindungen haben gegenüber klassischen Ausgangsverbindungen der CVD wie Metallhalogeniden oder Alkylen den Vorteil der niedrigen Abscheidungstemperatur (kleiner 300 °C), der hohen Stabilität in der Gasphase und der extrem hohen Flüchtigkeit (Verdampfungstemperatur unterhalb von 60 °C bei 10⁻³ mbar). Darüber hinaus sind sie i. d. R. leicht analysenrein darstellbar und besitzen nur eine geringe Toxizität.

Durch das erfindungsgemäße Chemical Vapor Deposition Verfahren (CVD-Verfahren) können Mikrokapillaren unterschiedlichen Innendurchmessers mit verschiedenen Funktionsmaterialien innenbeschichtet werden.

Durch Aufbringen ultradünner Metallfilme geringer Rauhigkeit können Mikrokapillaroptiken für verschiedenartige Anwendungen in der Röntgentechnik hergestellt werden. So gelingt die Fokussierung von mono- oder polychromatischer Röntgenstrahlung auf eine Spotgröße (Größe des bestrahlten Flecks) im Bereich weniger Mikrometer bei einem Gain-Faktor (Verstärkungsfaktor) von über 300. Diese Kennwerte stellen eine bisher noch unerreichte Dimension in der Röntgenfokussierung dar.

Unter bestimmten Bedingungen lassen sich auch Nanopartikel mit heterogenkatalytischen Eigenschaften abscheiden, die für heterogenkatalysierte Gasreaktionen einsetzbar sind. Bündel derartiger Kapillaren können als Durchflußreaktoren verwendet werden. So kann mit Hilfe von Kupfer/Zink-Katalysatoren eine Methanolsynthese aus Kohlendioxid und Wasserstoff erfolgen.

Die besonderen Vorteile der Beschichtungsmethode liegen, je nach Erfordernis, in der hohen Güte der aufgebrachten Schicht in bezug auf Rauhigkeit einerseits und Reflektivität andererseits.

Die Anwendung beschichteter Kapillarbündel in der heterogenen Katalyse hat gegenüber klassischen Verfahren den Vorteil zusätzlicher Steuerungsparameter wie Temperaturgradienten im Bereich weniger Millimeter sowie der leichten Kombinierbarkeit mit Methoden der Photolyse, Ultraschallbehandlung oder Mikrowellenanregung.

Die Erfindung wird im folgenden anhand von Ausführungsbeispielen mit Hilfe der Figuren näher erläutert.

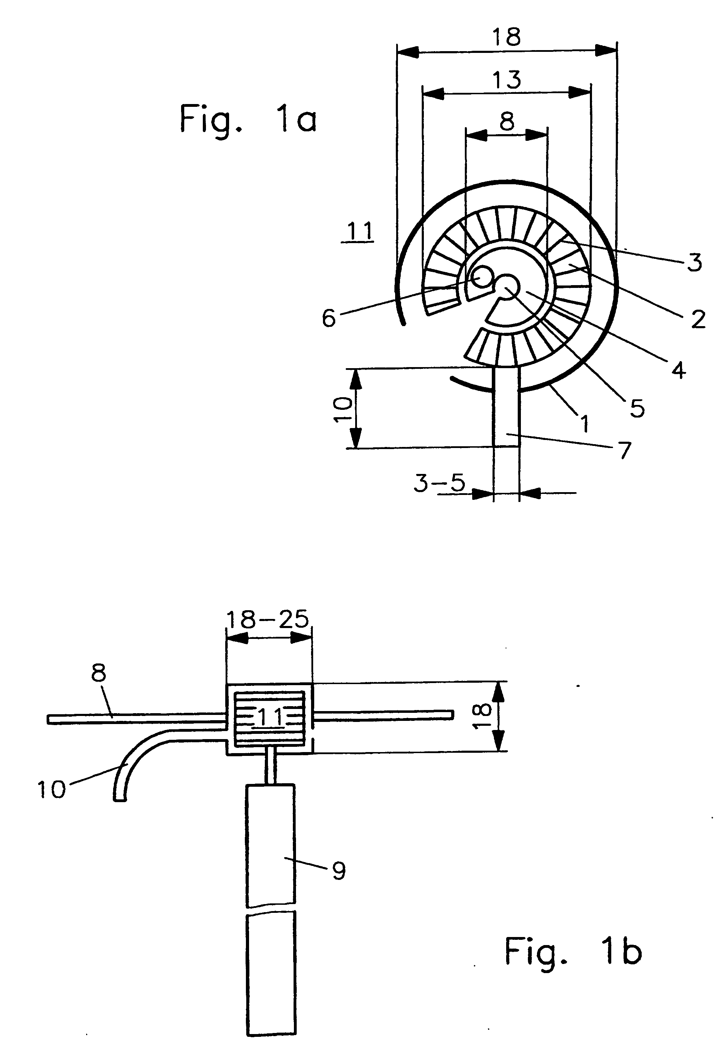

Dabei zeigt die Fig. 1a und 1b die schematische Darstellung eines Ofens für die Abscheidung und

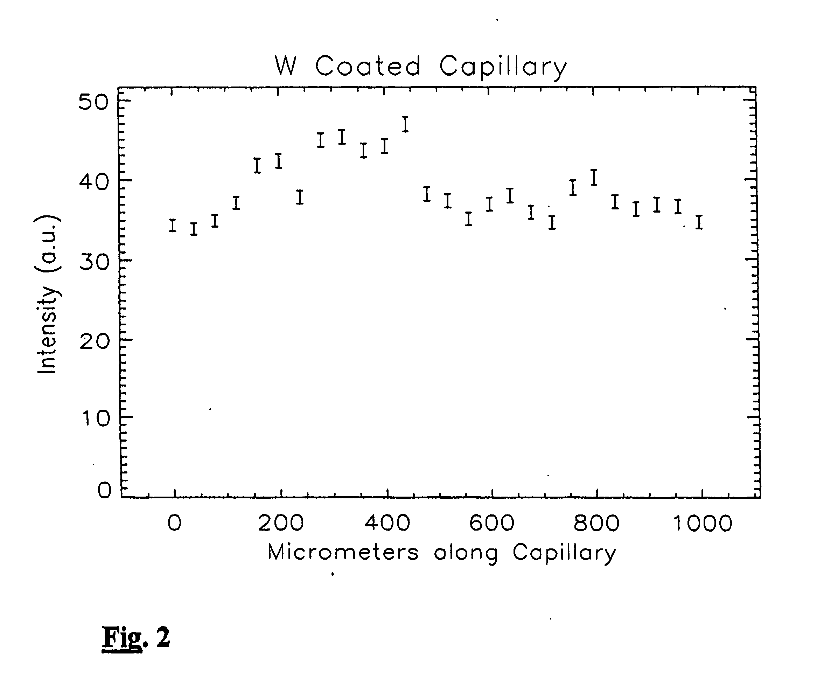

die Fig. 2 die Dicke einer abgeschiedenen Metallschicht über eine bestimmte Länge einer Kapillaren.

Das erfindungsgemäße Verfahren dient der Erzeugung dünner Schichten aus einzelnen Metallen oder Metalloxiden oder Gemischen oder mehrere Schichten derselben auf der Innenseite von Mikrokapillaren mit dem Ziel, die Reflektivität der Innenfläche gegenüber Röntgenstrahlung zu verbessern oder durch gezielte Erzeugung einer Verteilung von Nanopartikeln heterogen-katalysierte Reaktionen in Gasen oder Gasgemischen, die die Kapillare durchströmen, einzuleiten.

Die Fokussierung von Röntgenstrahlung mit Kapillaroptiken stellt eine relativ neue, sich z. Z. entwickelnde Technik dar. Es zeigt sich jedoch, daß unbeschichtete Glaskapillaren aufgrund von Entmischungsvorgängen an der Oberfläche eine Rauhigkeit aufweisen, die eine Fokussierung auf Gain-Faktoren von 100 - 300 limitieren. Ray-tracing-Berechnungen (Berechnungen über die Strahlgeometrie) belegen allerdings, daß theoretisch Gain-Faktoren von bis zu 1000 möglich sind. Diese können nur durch eine Minimierung der Rauhigkeit und eine Vergrößerung des Totalreflexionswinkels als Folge des anders gearteten reflektierenden Materials erreicht werden. Durch das Aufbringen einer metallischen Schicht aus Elementen mit hoher Kernladungszahl kann der Totalreflexionswinkel drastisch vergrößert werden.

Die zu beschichtende Oberfläche kann vorzugsweise mit Plasmabehandlung oder chemischem Ätzen geglättet werden.

Nach Aufbringen einer dünnen Metallschicht nach dem erfindungsgemäßen Verfahren wird aus den Kapillaren wie in der DE 44 44 102 C1 beschrieben, ein Röntgenkollimator erzeugt. Dabei wird die Kapillare bis zum Erweichen erhitzt und gezogen, wodurch die vorher erzeugte, rauhe Metalloberfläche geglättet wird.

Die heterogene Katalyse mit Hilfe von Metallkatalysatoren hat eine sehr große Zahl von Anwendungen in der großtechnischen chemischen Synthese, wobei hauptsächlich Netzkatalysatoren und Säulenschüttungen zum Einsatz kommen. Während Netzkatalysatoren, wie z. B. im Ostwald-Verfahren (Ammoniakverbrennung), sehr kurze Kontakzeiten (im Bereich von 10⁻⁴ s) gewährleisten, sind die Verweilzeiten im Falle der Säulenschüttungen vergleichsweise hoch.

Der Vorteil von Kapillarbündeln, die mit unserem Verfahren hergestellt werden können, liegt in der einstellbaren Strömungsgeschwindigkeit durch die Kapillare. Dadurch kann die Verweilzeit der Reaktanden an der Katalysatoroberfläche sowie des An- und Abdiffusionsprozesses exakt definiert werden.

Das Verfahren, welches mit hohen Dampfdrücken von OrganometallVerbindungen (Precursor) im Einlaßsystem arbeitet, kann auch zweistufig durchgeführt werden. Es ist bisher einmalig für Kapillaren.

In der ersten Phase kann die Oberfläche der in ein Vakuumsystem integrierten Kapillare in geeigneter Weise (Durchströmen reaktiver Gase, Plasma, Laser, chemische Modifikation mit z. B. Chlorsilanen, Durchströmen überkritischer Phasen mit Löseeigenschaften für Glas) vorbehandelt werden. Dadurch werden zum einen Unebenheiten innerhalb der Kapillaroberfläche geglättet, zum anderen bewirkt diese Verfahren eine Aktivierung der Oberfläche, die eine Verbesserung der Hafteigenschaften der nachfolgend aufgebrachten Schichten ermöglicht. So bewirkt z. B. die Behandlung der Kapillare mit einem RF-Plasma (Radiofrequenz-Plasma) eine deutliche Verringerung der Oberflächenrauhigkeit der Glasinnenwand (Plasmapolishing). Eine anschließend auf eine plasmabehandelte Oberfläche aufgebrachte Metallschicht zeigt im Vergleich zu einer unbehandelten Kapillare wesentlich verbesserte Haftung und eine geringere Rauhigkeit.

Für katalytische Verwendung kann die Vorbehandlung der Kapillaren (Glätten) entfallen, weil gerade die bereits vorhandende nanoporöse Oberfläche sich für die Ausbildung einer geeigneten Metallbeschichtung mit großer Oberfläche als günstig erweist.

Anschließend an diesen Reinigungsschritt erfolgt die Innenbeschichtung durch Zersetzung der Precursorverbindung unter Zufuhr von Energie an der Kapillarfläche.

Zum Zwecke der Innenbeschichtung werden die Mikrokapillaren, die einen Innendurchmesser von 0,1 bis 500 Mikrometern aufweisen können, von einem Gas des Ausgangsmaterials durchströmt, welches sich durch Zufuhr von Energie innerhalb der Kapillare zersetzt.

Zur Erzeugung des Gasstromes wird die Kapillare an beiden Enden gasdicht mit je einem Vakuumrezipienten verbunden (vgl. Skizze der Apparatur in Fig. 1a, b).

Die Adaption der Kapillare an das Vakuumsystem erfolgt z. B. mit Hilfe von temperaturstabilem Klebstoff, der nach dem Aushärten eine äußerst geringe Gasleckrate besitzt. Als mögliche Klebstoffe kommen dabei zweikomponentige Epoxidharzkleber oder Silikonklebstoffe zum Einsatz. Letztere haben eine Temperaturstabilität bis 300 °C, während die Epoxidharzkleber nur bis ca. 180 °C stabil und gasdicht bleiben.

Innerhalb des ersten Vakuumrezipienten befindet sich das gasförmige Ausgangsmaterial (Precursorsubstanz) unter einem Druck von 10-3 mbar bis 5 bar (je nach verwendetem Precursor sind unterschiedliche Einlaßdrücke erforderlich). Der zweite Rezipient wird durch Abpumpen auf Drücke im Bereich von 10⁻⁹ mbar bis 500 mbar gebracht, so daß über die Kapillare eine Druckdifferenz aufgebaut wird. Diese Druckdifferenz führt zur Ausbildung eines kontinuierlichen, homogenen Gasstromes aus Precursormolekülen durch die Kapillare. Das Precursoreinlaßsystem kann durch indirekte Heizung (z. B. mit Hilfe eines Umluftsystems, mit Heizschlangen, mit Mikrowellenheizung, induktiver Erwärmung oder durch Umspülen mit erhitzten Flüssigkeiten) auf Temperaturen von 20 bis 200 °C erwärmt werden, um die Flüchtigkeit der Precursorsubstanzen - und damit den Druck des Precursorgases vor Eintritt in die Kapillare - zu erhöhen. Alternativ kann auch ein Trägergas (z. B. Helium, Argon, Stickstoff, Wasserstoff oder Sauerstoff) mit dem Precursor beladen und durch die Kapillare gepumpt werden.

Zur Abscheidung der gewünschten Schicht wird dem Precursorgas innerhalb der Kapillare Energie in Form von Wärme, Licht, Plasma, ionisierender Strahlung, Röntgenstrahlung oder Mikrowellenstrahlung zugeführt.

Die thermische Zersetzung erfolgt mit Hilfe eines speziell entwickelten Ofens 11 (Fig. 1a, b). Dieser Ofen wird in seinem Inneren über einen Widerstandsdraht geheizt, die Innentemperatur wird über ein Ni-CrNi-Thermoelement gemessen und über eine Regelelektronik exakt eingestellt. Der einstellbare Temperaturbereich liegt zwischen 20 und 1000 °C.

Die Fig. 1a zeigt eine Seitenansicht und unten eine um 90° gedrehte Ansicht des Ofens 11 mit beispielhaften Bemaßungsangaben. Bei der oben dargestellten Seitenansicht trägt der Halter 7 von außen nach innen ein zylinderförmiges Abschirmblech 1, eine erste Keramikhülse 2 mit einem spiralig gewickelten Heizdraht 3 und eine innere Keramikhülse 4 mit einer Bohrung 5 zur Aufnahme der Kapillaren 8 und einer Bohrung 6 zur Aufnahme eines Thermoelements (NiCrNi- Mantelthermoelement). Die gedrehte Darstellung bei Fig. 1b zeigt außerdem die Kapillare 8, das Thermoelement 10 und die Halterung 9 für den Halter 7, welch der Wärmeisolierung dient. Der Ofen weist einen schmalen Längsschlitz auf, mit Hilfe dessen er über die Kapillare gestülpt werden kann. Beim Betrieb sollte er zur Vermeidung von Wärmeverlusten mit einem Deckel aus reflektierendem und wärmedämmendem Material verschlossen sein. Die Pfeile zeigen Bemaßungen in Millimetern.

Um eine gleichmäßige Beschichtung über die gesamte Länge der Kapillare zu erreichen, ist es notwendig, den Minireaktor entlang der Kapillarachse zu bewegen. Je nach Erfordernis der Metallabscheidung wird der Ofen mit konstanter Geschwindigkeit ein- oder mehrfach über die Kapillare geführt. Diese Bewegung wird mit Hilfe einer elektronisch oder mechanisch gesteuerten Vorschubtechnik realisiert.

Neben dieser rein thermischen Zersetzungsmethode kann die notwendige Energie zur Abscheidung der Funktionsschichten auch photochemisch bereitgestellt werden. Die photochemische Aktivierung eignet sich besonders zur Abscheidung von Metallfilmen aus metallorganischen Precursorverbindungen, da diese häufig leicht durch Einwirkung von Licht zersetzt werden können. Diese Abscheidungsmethode bietet zudem den Vorteil, daß bereits aufgebrachter Metallfilm ab einer bestimmten, von der Absorption des jeweiligen Metalles im Wellenlängenbereich des eintretenden Lichtes abhängigen Dicke, den Zutritt weiterer Strahlungsenergie verhindert, wodurch lokale Inhomogenitäten vermieden werden. Die maximale Schichtdicke ist in diesem Fall systemimmanent.

Eine weitere Möglichkeit zur Aktivierung der Precursorsubstanzen innerhalb der Kapillare stellt die Plasmatechnik dar. Sie kann zum einen zur direkten Abscheidung der gewünschten Schicht in der Kapillare benutzt werden, zum anderen kann durch Plasmabehandlung der Glasoberfläche bei Abwesenheit von Precursorgas eine Verbesserung der Haftungseigenschaften der anschließend aufgebrachten Funktionsschichten erreicht werden.

Zur plasmagestützten Durchführung des CVD-Prozesses (PECVD - plasma enhanced chemical vapor deposition) werden am Einlaß (Vakuumrezipient höheren Druckes) und Auslaß der Kapillare (Vakuumrezipient niedrigeren Druckes) Kupferelektroden angebracht, zwischen denen über einen Plasmagenerator ein hochfrequentes Wechselfeld angelegt wird. Läßt man gleichzeitig ein Inertgas (z. B. Argon, Helium), ein Reaktivgas (z. B. Wasserstoff, Sauerstoff, Stickstoff, etc.) oder reines Precursorgas durch die Kapillare strömen, so werden die Gasteilchen innerhalb des Wechselfeldes ionisiert und ein Plasma entsteht. Die eingestrahlte Energie variiert dabei zwischen 0 und 600 Watt. Für Kapillaren, bei denen ein Zuwachsen der Schicht droht, kann ein Hochfrequenzspannungsgenerator (Plasmapistole) eingesetzt werden.

Die Kontrolle der während des CVD-Prozesses ablaufenden chemischen Reaktionen erfolgt über das angeschlossene Quadrupolmassenspektrometer. Dazu werden Massenspektren der Zersetzungsgase aufgezeichnet, die eine Steuerung der Prozeßparameter (Precursorgasdruck, Abscheidungstemperatur, Verdampfungstemperatur, etc.) über die Optimierung einzelner Massenpeaks ermöglichen. Beispielsweise kann bei Abscheidung von Wolfram durch Zersetzung von Hexacarbonylwolfram der Massenpeak von Kohlenmonoxid unter Beachtung der Vakuumbedingungen maximiert werden. Für die Abscheidung von Palladium aus Hexafluoroacetylacetonatopalladium(II) kann die Optimierung der Abscheidungsbedingungen über ein Maximierung des CF₃-Massenpeaks erfolgen. Darüber hinaus kann alleine oder in Verbindung mit dem vorhergenannten zur Optimierung der Metallabscheidung die Minimierung des Metall-/Metalligandfragment-Peaks herangezogen werden.

Mit dem beschriebenen Verfahren können Mikrokapillaren aus unterschiedlichsten Materialien beschichtet werden. Durchgeführt wurden die Beschichtungen bisher mit Glaskapillaren aus Duran, Bleiglas und Quarz, jedoch sind auch Metall-, Keramik- oder Kunststoffkapillaren als Substrate einsetzbar.

Keramikkapillaren können analog dem Verfahren gemäß der DE 4409340 hergestellt werden, wobei der eingelegte Faden nach der Herstellung des Keramikkörpers (z. B.durch Sintern) entfernt wird.

Mit Ausnahme der Kunststoffkapillaren können nach der Zersetzung der Organometall-Verbindung durch Überleiten eines sauerstoffhaltigen Gases die bei der Abscheidung in der Schicht enthaltenen kohlenstoffhaltigen Verunreinigungen verbrannt werden. Dadurch wird die katalytische Aktivität der Kapillare erhöht.

Die Ausgangsverbindungen für den Prozeß können nach dem jeweiligen Anwendungszweck ausgewählt werden. Um erfolgreich als Precursor in einem CVD-Verfahren eingesetzt zu werden, muß eine Verbindung folgende Kriterien erfüllen:
- eine hohe Flüchtigkeit auch bei hohen Drücken
- eine hinreichende Stabilität in der Gasphase
- eine Zersetzbarkeit zu definierten Produkten
- möglichst niedrige Abscheidungstemperaturen (<1000 °C)
- eine Möglichkeit zur analysenreinen Darstellung.

Diese Kriterien gelten auch für das von uns entwicklte CVD-Verfahren, wobei nahezu alle Verbindungen, die auch in der klassischen CVD-Technik Verwendung finden, hier als Precursorsysteme eingesetzt werden. Im besonderen Maße funktioniert unser System mit leicht flüchtigen Organometallverbindungen. Einige Beispiele für literaturbekannte Ausgangsverbindungen sind in folgendem Absatz aufgeführt:
- (2-Butin)(hexafluoracetylacetonato)kupfer
- (Hexafluoracetylacetonato)(vinyltrimethylsilan)kupfer
- (1,5-Cyclooctadien)(hexafluoracetylacetonato)kupfer
- ((3-Allyl)(hexafluoracetylacetonato)palladium
- (Dicarbonyl)(2,4-pentandionato)rhodium(I)
- Tetraethylblei
- Hexacarbonylchrom
- Hexacarbonylmolybdän
- Hexacarbonylwolfram
- (Dimethyl)(hexafluoracetylacetonato)gold

Diese Verbindungen besitzen eine gute Zersetzungskinetik, können in hohen Wachstumssraten bei niedrigen Zersetzungstemperaturen abgeschieden werden und sind zudem noch auf einfachem Wege synthetisierbar. Sie sind - mit Ausnahme des Bleitetraethyls - nur wenig toxisch.

Die Verwendung dieser Substanzen als Precursormaterialien in dem von uns entwickelten CVD-Prozeß führt zur Bildung metallischer Filme der in den Precursorsubstanzen enthaltenen Metallkomponente. Die Metallschichten besitzen auf den Glasoberflächen eine gute Haftung, sind homogen und von geringer Rauhigkeit, wenn vor der Beschichtung geglättet wird. Die geringe Rauhigkeit ist für Verwendung von Kapillaroptiken für Röntgen- und Gammastrahlung erforderlich.

Zur Darstellung von Funktionsschichten mit mikrokristalliner Oberfläche in Kapillaren können z. B. flüchtige Palladium- und Kupferverbindungen, die mindestens einen Hexafluoracetylacetonatoliganden tragen, dienen. Diese Verbindungen lassen sich in unserer CVD-Apparatur durch gezielte Variation der Prozeßparameter (s. u.) zu Schichten mit hoher Oberflächenaktivität abscheiden. Während des Beschichtungsprozesses bilden sich in statistischer Verteilung Kristallite an der Glaswand, welche zu einer erhöhten Oberflächenrauhigkeit führen. Diese ist für eine heterogen-katalytische Wirksamkeit von Vorteil.

Eine erhöhte Oberflächenrauhigkeit kann dadurch erreicht werden, daß vor der Abscheidung des eigentlich katalytisch wirksamen Metalls eine Metalloxid- oder -nitrid-Schicht in der Kapillare aufgetragen wird. Durch diese vorhergehende Abscheidung von Keramiken werden nanostrukturierte Oberflächen erhalten, deren Nanoporosität nach der Metallabscheidung eine höhere katalytische Aktivität mit selektiveren Eigenschaften liefert.

Oxidschichten können abgeschieden werden, indem der Precursor in einem Sauerstoff- oder Distickstoffoxidstrom zersetzt wird. Eine andere Möglichkeit ist die Abscheidung von sauerstoffhaltigen Precursoren. Ein Beispiel für den ersten Fall ist die Abscheidung von Aluminiumoxid aus Trimethylaluminium (TMA) zusammen mit Sauerstoff, für den zweiten die Abscheidung von Zirkoniumoxid durch Pyrolyse von Zirkoniumalkoxiden.

Metallnitride können erzeugt werden, indem die entsprechende Metallverbindung zusammen mit Stickstoff oder Ammoniak zersetzt wird, z. B. Titannitrid aus Titantetrachlorid zusammen mit Ammoniak, oder die entsprechende stickstoffhaltige Organometallverbindung im CVD-verfahren eingesetzt wird, z. B. Titantetrakis(dialkylamide).

Eine Erweiterung der katalytischen Anwendung innenbeschichteter Kapillaren ist der Einsatz spiralförmiger Kapillaren, die auf entsprechende Weise beschichtet werden können. Vorteil der spiralförmig gebogenen Kapillaren ist die Verwirbelung des Gasstromes.

Ein weiteres Anwendungsgebiet der metallbeschichteten Kapillaren ist die Analytik, wobei in gaschromatischen sowie chromatischen Untersuchungen in superkritischen Medien (wie z. B. CO₂) der Trennvorgang durch das Gleichgewicht zwischen Gas- bzw. gelöster Phase und Adsorption auf der nanostrukturierten Oberfläche durch CVD erzeugten Oberfläche (Metall, Metalloxid, -nitrid) erzielt wird.

Vorgehensweise bei der Innenbeschichtung einer Glaskapillare:

Eine konische Duranglaskapillare wird in die Öffnungen zweier Metall-Glasadapter eingelegt und mit Zweikomponentenkleber vakuumdicht eingeklebt. Nach einer Aushärtezeit von ca. 30 min wird das gesamte System evakuiert, wobei hochvakuumseitig ein Druck von 10⁻⁷ bis 10⁻⁸ mbar, im Bereich des Precursoreinlaßsystemes ein Druck von 10⁻² bis 10⁻³ mbar erreicht werden sollte. Sodann wird das Vorvakuumsystem mit Heliumgas geflutet und mit Hilfe des Quadrupolmassenspektrometers der Durchgang der Kapillare kontrolliert. Mit dieser Vorgehensweise können Lecks innerhalb des Vakuumsystems sowie Verstopfungen der Kapillare (etwa durch eintretenden Klebstoff in die Kapillaröffnung) frühzeitig erkannt werden.

Feste oder flüssige Precursorverbindungen werden nun in die Vorlage des Verdampfersystems eingefüllt. Nach erneutem Evakuieren auf Drücke im Bereich von 10 mbar bis 10⁻³ mbar (je nach Flüchtigkeit der verwendeten Ausgangsverbindung) wird die Temperatur des Verdampfers gegebenenfalls sukzessive bis zum Sublimationspunkt des Precursors bei gegebenem Druck erhöht. Die Sublimationstemperatur liegt bei den von uns verwendeten metallorganischen Precursorverbindungen im Bereich zwischen RT und 100 °C. Gasförmige Precursorverbindungen (z. B. SiH₄, AsH₃, o. ä.) sowie Reaktivgase (NH₃, H₂, O₂) werden über Massflow-Controller (Massenfluß-Nachweisgeräte) und stufenlos regulierbare Einlaßventile in das Verdampfungssystem gebracht. Nach kurzer Wartezeit kann mit dem Massenspektrometer des Hochvakuumrezipienten kontrolliert werden, ob sich ein kontinuierlicher Gasfluß durch die Kapillare eingestellt hat. Die Druckdifferenz zwischen Hochvakuum- und Verdampfersystem liegt zwischen 10⁻² und 1000 mbar je nach verwendetem Precursor.

Anschließend wird das Reaktorsystem eingeschaltet und mit einer Vorschubgeschwindigkeit im Bereich von 10 - 0,01 mm/s entlang der Kapillarachse bewegt. Bei Verwendung des Mikroofens zur thermischen Zersetzung wird je nach verwendetem Precursor und Kapillarmaterial eine Temperatur von 200 bis 1000 °C eingestellt. Soll die Abscheidung photochemisch erfolgen, so wird die gesamte Kapillare während der Beschichtung mit Hilfe einer Quecksilberdampflampe bestrahlt.

Während des gesamten Prozesses wird die Zusammensetzung des aus der Kapillare in den Hochvakuumrezipienten strömenden Zersetzungsgasgemisches kontrolliert, so daß gegebenenfalls Abscheidungsparameter (Temperatur des Verdampfersystems, Temperatur des Zersetzungsofens (bei thermischer Zersetzung), Energie und Abstand der Quecksilberlampe (bei photochemischer Zersetzung), Fokalpunkt des Lasers (bei laserinduzierter Zersetzung), Vorschubgeschwindigkeit des Reaktors, usw.) noch während der Abscheidung optimiert werden können.

Nach einer Beschichtungszeit von 5 min bis zu mehreren Stunden, je nach gewünschter Schichtdicke, ist der Abscheidungsvorgang beendet, und die Kapillare kann ausgebaut werden.

Soll die Kapillare für heterogenkatalytische Reaktionen eingesetzt werden, so ist müssen bereits während der Beschichtung die Abscheidungsparameter dahingehend eingestellt werden, daß eine möglichst große Oberfläche mit Nanokristalliten entsteht. Rasterelektronenmikroskopische Aufnahmen geöffneter Kapillaren, beschichtet mit Kupfer oder Palladium aus 2-Butin(hexafluoracetylacetonato)kupfer oder Allyl(hexafluoracetylacetonato) palladium bei einer Abscheidungstemperatur von 400 °C, zeigen eine insgesamt homogene, jedoch rauhe Oberfläche.

Bei Verwendung von 2-Butin(hexafluoracetylacetonato)kupfer als Precursor bestehen sie aus elementarem Kupfer, wird Allyl(hexafluoracetylacetonato)palladium als Ausgangsverbindung verwendet, entstehen Palladiumkristallite, die ca. 100 Nanometer groß sind. Mit unserem Verfahren ist es also möglich, Schichten aus Nanokristalliten herzustellen, die katalytisch aktiv sind.

### Röntgenfokussierung

Insbesondere die Fokussierung von Röntgenstrahlung stellt eine bei uns bereits erprobte Anwendung unserer Technik dar. Die Kapillaren - in der Regel konisch oder elliptisch geformte Glaskapillaren aus Duran, Bleiglas oder Quarz - werden dazu an ihrer Innenfläche mit dünnen Metallfilmen beschichtet. Diese Metallschichten bewirken eine Vergrößerung des Totalreflexionswinkels, woraus eine deutliche Verbesserung der Röntgenfokussierungseigenschaften resultiert.

Kapillaroptiken sind neuartige Instrumente zur Fokussierung von Röntgenstrahlung auf Strahldurchmesser unterhalb 5 µm und verbessern somit die Ortsauflösung von Röntgenanalysegeräten (z. B. Mikro-Fluoreszenzanalyse, Mikro-Diffraktometrie, Mikrotomographie, Röntgenphotoelektronenspektroskopie) um mehr als eine Größenordnung im Vergleich zu herkömmlichen Pinhole-Systemen (Systeme mit Lochblenden). Außerdem wird eine Erhöhung der Flußdichte (Photonen pro Fläche) um 2-3 Größenordnungen bewirkt. Dies ist möglich durch i.a. mehrfache (angestrebt wird derzeit einfache) Totalreflexion der Photonen an der Innenoberfläche der Kapillare, deren Querschnitt sich längs der Achse stark verringert. Auf diese Weise wird der in die Kapillare eintretende Strahl auf einen um ein bis zwei Größenordnungen kleineren Durchmesser zusammengeschnürt. Um die für die analytischen Anwendungen entscheidende maximale Strahlintensität zu erhalten, muß neben der geometrischen Form der Kapillaroptik die Reflexionswahrscheinlichkeit der Photonen an der Innenoberfläche der Kapillare optimiert werden. Dazu muß, neben einer minimalen Rauhigkeit der Oberfläche, sichergestellt sein, daß der kritische Winkel für die Totalreflexion nicht überschritten wird. Da dieser mit der Ordnungszahl des Elements ansteigt, kann die Transmission der Kapillare durch Beschichtung der Innenoberfläche mit einem Element mit großem Z verbessert werden.

Zur Messung der Transmission von beschichteten und unbeschichteten Glaskapillaren haben wir die Röntgenmikrosonde am weißen Synchrotronstrahl des HASYLAB verwendet. Die zu untersuchende Kapillare wird auf einer 4-Achsen-Justiereinheit montiert, die horizontale und vertikale Translation sowie Drehung um die horizontale und die vertikale Achse in Schritten von 1.25 µm bzw. 13 µrad ermöglicht. Die Position und Helligkeit des durch die Kapillare transmittierten Strahls wird auf einem Leuchtschirm beobachtet. Die transmittierte Strahlintensität wird mit einer Ionisationskammer gemessen. Eine 3 mm dicke Ta-Blende vor der Kapillare stellt sicher, daß kein Teil des Strahls an der Kapillare vorbei in den Detektionsbereich gelangen kann. Die Kapillare muß genau auf die Achse des nahezu parallelen Synchrotronstrahls gebracht werden. Um diese Position zu finden, werden Position und Neigung der Kapillare so lange variiert, bis die transmittierte Strahlintensität maximal ist. Der erhaltene Wert hängt stark von der Oberflächengüte der verwendeten Kapillare ab. Mit einer Cr-Beschichtung der Innenoberfläche mittels MOCVD haben wir bei einer zylindrischen Kapillare mit 30 µm Innendurchmesser eine Erhöhung der transmittierten Intensität von 68% auf 100% des einfallenden Strahls erreicht.

Die Optimierung des MOCVD-Prozesses erfordert die Kenntnis der Homogenität der abgeschiedenen Metallschichten längs der Kapillarachse. Diese wird an der Röntgenmikrosonde am Synchrotronstrahl des HASYLAB gemessen. Dazu wird die zu untersuchende Kapillare senkrecht auf einem XYZ-Tisch montiert und auf den Synchrotronstrahl justiert. Der auf eine geeignete Größe ausgeblendete Strahl durchdringt das Glas und die in der Kapillare befindliche Metallschicht. In der Metallschicht wird Fluoreszenzstrahlung ausgelöst, die das Glas der Kapillare durchdringt und mit einem HPGe-Detektor unter 90° zum einfallenden Strahl energiedispersiv nachgewiesen wird. Die Größe des Fluoreszenzsignals ist dabei proportional zu der Menge des in dem untersuchten Volumen abgeschiedenen Metalls. Die Verteilung des Metalls wird untersucht, indem die Kapillare längs ihrer Achse durch den Strahl gefahren wird.

In Fig. 2 ist beispielhaft die Verteilung von W längs 1 mm in einer W-beschichteten Duranglaskapillare aufgetragen.

Die angegebenen Schwankungsbreiten der Ergebnisse beziehen sich auf den statistischen Fehler aus den Zählraten der einzelnen Messungen. Auf diese Weise kann die Verteilung des abgeschiedenen Metalls längs der Kapillarachse in Abhängigkeit von den Parametern des MOCVD-Prozesses bestimmt und die Homogenität der Schicht optimiert werden. Der Vorteil der Verwendung des Synchrotronstrahls bei diesen Messungen liegt neben der hohen Strahlintensität auch darin, daß der durch Streuung am Glas entstehende Untergrund durch die lineare Polarisation des Strahls in der Ringebene des Beschleunigers stark reduziert wird. Auf diese Weise kann die Metallschicht im Inneren der Kapillare zerstörungsfrei untersucht werden; ein Aufschneiden der Kapillare ist bei dieser Methode nicht erforderlich.

### Heterogene Katalyse

Ein noch junges Anwendungsfeld unserer beschichteten Mikrokapillaren stellt die heterogene Katalyse von Gasreaktionen dar. Dabei werden die Reaktanden durch eine mit Nanokristalliten katalytisch wirksamer Stoffe beschichtete Kapillare geleitet und dort unter Zufuhr von Energie zur Reaktion gebracht.

Die Kapillare wird dazu in die Glasenden zweier Metall-Glasadapter eingeführt und mit Zweikomponetenkleber beidseitig verklebt. Nach einer Härtezeit wird das gesamte System evakuiert, einlaßseitig mit Helium geflutet und so auf Durchgängigkeit geprüft. Man evakuiert das Vorvakuumsystem erneut und läßt die Reaktanden über Massflow-Controller im gewünschten Molverhältnis in das Vorsystem ein. Dabei ist es erforderlich die Massflow-Controller auf die verwendete Gasart zu eichen, um exakte Mischungsverhältnisse zu erreichen. Sodann wird das Einlaßventil zur Kapillare geöffnet und ein kontinuerlicher Gasstrom erzeugt. Dies ist an den sich nicht verändernden Peakhöhen in den während des gesamten Prozesses aufgezeichneten Massenspektren erkennbar. Die Zufuhr an Reaktanden in das Vorvakuumsystem ist so einzustellen, daß der Druck im Vorvakuumsystem während der gesamten Reaktion nahezu konstant bleibt. Ist ein stetiger Gasstrom erzeugt, wird die Reaktion im Inneren der Kapillare durch Zufuhr von Energie eingeleitet.

Je nach verwendetem System können bei thermischer Aktivierung Temperaturen von 20 bis zu 1000 °C eingestellt werden. Die Druckdifferenz zwischen Einlaßsystem und HV-System (Hochvakuum-System) liegt zwischen 10⁻¹ und ca. 3000 mbar. Insbesondere bei hohen Einlaßdrücken und dünnen Kapillaren (unterhalb von 100 µm) muß für eine gute Durchmischung der Reaktanden vor dem Eintritt in das Reaktorsystem gesorgt werden, da ansonsten leicht Konzentrationsschwankungen auftreten, die zu unvollständiger Reaktion führen. Die von uns entwickelten nanokristallinen Metall- und Metalloxidoberflächen werden derzeit von uns intensiv untersucht.

So gelingt an Palladiumschichten die Enthalogenierung von Aromaten wie Chlorbenzol und 1,2,4-Trichlorbenzol mit Hilfe von Wasserstoff. Dabei entsteht Benzol. Mit der vorgestellten Methode lassen sich z. B. Kohlenmonoxid und Wasserstoff bei Temperaturen im Bereich von 400 bis 600 °C an einer mikrokristallinen Palladiumoberfläche zu Methanol umsetzen. An Rhodiumschichten gelingt zusätzlich zur Enthalogenierung der Aromaten die Reduktion von CO₂ mit Wasserstoff zu Methan und CO, sowie die Dechlorierung von 1,1,2-Trichlortrifluorethan und 1,2-Dichlorethan.

An Palladium und Rhodium können Kohlenwasserstoffe bei Temperaturen um 200 °C mit Sauerstoff zu CO₂ verbrannt werden.

Die möglichen Anwendungen sind im folgenden noch einmal zusammengefaßt.

Die beschichteten Kapillaren eignen sich als Kapillaroptiken und für die Katalyse in der Gasphase und die Analytik.

Innenbeschichtete Kapillaren eignen sich für eine ganze Reihe metallgestützter Katalysereaktionen:
Enthalogenierung von halogenierten Kohlenwasserstoffen Reduktion von CO₂,
H/D-Austausch,
Reaktion von CO und NO zu CO₂ und N₂ ("Drei-Wege-Katalysator"),
Methanolsynthese aus Synthesegas,
Hydrierungsreaktionen von ungesättigten Verbindungen,
Metathese von Olefinen und
Verbrennen von Kohlenwasserstoffen zu CO₂ in superkritischen Flüssigkeiten.

Die metallbeschichteten Kapillaren sind auch zum Einsatz von heterogenen, metall-gestützten Katalysen in superkritischen Flüssigkeiten (z.B. CO₂) geeignet.

## Patentansprüche

1. Verfahren zur Innenbeschichtung von Kapillaren mit folgenden Verfahrensschritten:
a) Evakuieren einer Kapillare, wobei an den beiden Enden der Kapillaren ein Druckunterschied besteht,
b) Verdampfen einer Organometall-Verbindung und Leiten dieses Dampfes durch die Kapillare, wobei der Transport durch den Druckgradienten geschieht,
c) Abscheiden des Metalles aus dem Dampf der Organometall-Verbindung durch Zufuhr von Energie und
d) Analysieren der gasförmigen Zersetzungsprodukte, die bei der Abscheidung des Metalles entstehen, mit einem Massenspektrometer,
wobei über die Intensität auswählbarer Massenpeaks die Zersetzungsparameter eingestellt werden.

2. Verfahren nach Anspruch 1, **dadurch gekennzeichnet, daß** dem Dampf der Organometall-Verbindung ein Trägergas beigemischt wird.

3. Verfahren nach Anspruch 1 öder 2, **dadurch gekennzeichnet, daß** nach der Metallabscheidung sauerstoffhaltiges Gas durch die Kapillare geleitet wird, wobei bei ausreichender Temperatur mit abgeschiedener Kohlenstoff verbrannt und ausgespült wird.

4. Verfahren nach einem der Ansprüche 1 bis 3, **dadurch gekennzeichnet, daß** vor der Metallabscheidung auf der Kapillareninnenfläche mit Hilfe von Gasphasenabscheidung Metalloxid abgeschieden wird.

5. Verfahren nach einem der Ansprüche 1 bis 4, **dadurch gekennzeichnet, daß** vor der Metallabscheidung auf der Kapillareninnenfläche mit Hilfe von Gasphasenabscheidung Metallnitrid abgeschieden wird.

6. Verfahren nach einem der Ansprüche 1 bis 5, **dadurch gekennzeichnet, daß** für die für die Metallabscheidung nötige Energiezufuhr ein über die Länge der Kapillare verschiebbarer Ofen verwendet wird.

7. Verfahren nach einem der Ansprüche 1 bis 5, **dadurch gekennzeichnet, daß** für die für die Metallabscheidung nötige Energiezufuhr ein über die Länge der Kapillare verschiebbarer Laser verwendet wird.

8. Verfahren nach einem der Ansprüche 1 bis 5, **dadurch gekennzeichnet, daß** für die für die Metallabscheidung nötige Energiezufuhr ein Plasmagenerator verwendet wird.

9. Verfahren nach einem der Ansprüche 1 bis 8, **dadurch gekennzeichnet, daß** die Innenoberfläche der Kapillaren vor der Metallabscheidung mit Plasmabehandlung oder mit chemischem Ätzen geglättet wird.

10. Verwendung einer Kapillare beschichtet nach einem Verfahren gemäß einem der Ansprüche 1 bis 9 zur katalytischen Reaktionsbeschleunigung oder für Trennverfahren.

11. Verwendung einer Kapillare beschichtet nach einem Verfahren gemäß einem der Ansprüche 1 bis 9 zur Erzeugung einer geformten Kapillare zur Fokussierung von Röntgenstrahlung.

## Claims

1. Process for the inner coating of capillaries, consisting of the following process steps:
a) Evacuation of a capillary, with a pressure difference existing between both ends of the capillary,
b) evaporation of an organometal compound, with the vapor being transported through the capillary as a result of the pressure gradient,
c) deposition of metal from the vapor of the organometal compound by the supply of energy, and
d) analysis of the gaseous decomposition products generated by the deposition of the metal using a mass spectrometer,
with the decomposition parameters being set by the intensity of the mass peaks selected.

2. Process according to Claim 1, **characterized by** a carrier gas being admixed to the vapor of the organometal compound.

3. Process according to Claim 1 or 2, **characterized by** an oxygen-containing gas being passed through the capillary after metal deposition and co-deposited carbon being combusted and removed at a sufficiently high temperature.

4. Process according to one of Claims 1 through 3, **characterized by** a metal oxide being deposited on the inner surface of the capillary by a gas-phase deposition prior to metal deposition.

5. Process according to one of Claims 1 through 4, **characterized by** a metal nitride being deposited on the inner surface of the capillary by gas-phase deposition prior to metal deposition.

6. Process according to one of Claims 1 through 5, **characterized by** the energy needed for metal deposition being supplied by a furnace that can be shifted along the length of the capillary.

7. Process according to one of Claims 1 through 5, **characterized by** the energy needed for metal deposition being supplied by a laser that can be shifted along the length of the capillary.

8. Process according to one of Claims 1 through 5, **characterized by** the energy needed for metal deposition being generated by a plasma generator.

9. Process according to one of Claims 1 through 8, **characterized by** the inner surface of the capillary being smoothed by a plasma treatment or by chemical etching prior to metal deposition.

10. Use of a capillary coated by a process according to one of Claims 1 through 9 for accelerating catalytic reaction or for separation processes.

11. Use of a capillary coated by a process according to one of Claims 1 through 9 for generating a shaped capillary to focus X-radiation.

## Revendications

1. Procédé d'application d'un revêtement intérieur à des capillaires , comprenant les opérations suivantes:
a) Faire le vide d'une capillaire, une différence de pression existant aux deux extrémités des capillaires,
b) Evaporer un composé organométallique et conduire cette vapeur à travers les capillaires, le transport se réalisant grâce au gradient de pression,
c) Séparer le métal à partir de la vapeur du composé organométallique par alimentation en énergie et
d) Analyser au spectromètre de masse les produits de décomposition formés lors de la séparation du métal,
les paramètres de décomposition étant réglés par l'intermédiaire de l'intensité des pics de masse à sélectionner.

2. Procédé selon la revendication 1, **caractérisé en ce qu'**un gaz porteur est ajouté à la vapeur du composé organométallique.

3. Procédé selon la revendication 1 ou 2, **caractérisé en ce qu'**après la séparation du métal, du gaz contenant de l'oxygène est conduit à travers les capillaires, le carbone séparé simultanément à une température suffisante étant brûlé et expulsé.

4. Procédé selon l'une quelconque des revendications 1 à 3, **caractérisé en ce qu'**avant la séparation du métal sur la face intérieure de la capillaire, de l'oxyde métallique est séparé par dépôt chimique en phase vapeur.

5. Procédé selon l'une quelconque des revendications 1 à 4, **caractérisé en ce qu'**avant la séparation du métal sur la face intérieure de la capillaire, du nitrure de métal est séparé par dépôt chimique en phase vapeur.

6. Procédé selon l'une quelconque des revendications 1 à 5, **caractérisé en ce que** pour l'alimentation en énergie nécessaire pour la séparation du métal, on utilise un four déplaçable sur la longueur de la capillaire.

7. Procédé selon l'une quelconque des revendications 1 à 5, **caractérisé en ce que** pour l'alimentation en énergie nécessaire pour la séparation du métal, on utilise un laser déplaçable sur la longueur de la capillaire.

8. Procédé selon l'une quelconque des revendications 1 à 5, **caractérisé en ce que** pour l'alimentation en énergie nécessaire pour la séparation du métal, on utilise un générateur de plasma.

9. Procédé selon l'une quelconque des revendications 1 à 8, **caractérisé en ce qu'**avant la séparation du métal, la surface intérieure des capillaires est lissée par traitement à plasma ou par attaque chimique.

10. Utilisation d'une capillaire revêtue conformément à un procédé selon l'une des revendications 1 à 9 pour l'accélération catalytique de la réaction ou pour des procédés de séparation.

11. Utilisation d'une capillaire revêtue conformément à un procédé selon l'une des revendications 1 à 9 pour la production d'une capillaire formée pour la focalisation de rayons X.
